# EUROPEAN PATENT APPLICATION

(11) **EP 4 692 025 A1**
(43) Date of publication of application: **11.02.2026**
(21) Application number: 24780083.2
(22) Date of filing: 22.03.2024
(51) Int. Cl.: C04B 35/587, C04B 35/581, C04B 37/02, H01L 23/12, H05K 1/03

(54) **CERAMIC SUBSTRATE, CERAMIC CIRCUIT BOARD, SEMICONDUCTOR DEVICE, METHOD FOR PRODUCING SLURRY, AND METHOD FOR APPLYING RELEASE AGENT**

(30) Priority: 24.03.2023 JP 2023047425
(71) Applicant: Niterra Materials Co., Ltd., Yokohama-shi, Kanagawa 235-0032 (JP)
(72) Inventor: ITO, Zen, Yokohama-shi, Kanagawa 235-0032 (JP); HIGUCHI, Masaaki, Yokohama-shi, Kanagawa 235-0032 (JP); IMANAKA, Keita, Yokohama-shi, Kanagawa 235-0032 (JP); KIMURA, Masamitsu, Yokohama-shi, Kanagawa 235-0032 (JP); KONDO, Hiroyasu, Yokohama-shi, Kanagawa 235-0032 (JP)
(74) Representative: Hoffmann Eitle
(86) International application number: PCT/JP2024/011508
(87) International publication number: WO 2024/203965

(57) **Abstract**

A ceramic substrate according to an embodiment has a first surface as a front surface and a second surface as a back surface, when a midpoint of a line segment connecting a central portion P1 of the first surface and a central portion P2 of the second surface is defined as a midpoint portion C1, an amount of a component of a release agent measured at the central portion P1 of the first surface or the central portion P2 of the second surface is five times or more an amount of the component of the release agent measured at the midpoint portion C1. A ratio P1/P2 between the amount of the component of the release agent measured at the central portion P1 and the amount of the component of the release agent measured at the central portion P2 preferably satisfies 0.5 ≤ P1/P2 ≤ 2.

## Description

### TECHNICAL FIELD

Embodiments of the present invention generally relate to a ceramic substrate, a ceramic circuit board, a semiconductor device, a method for producing a slurry, and a method for applying a release agent.

### BACKGROUND ART

A ceramic substrate is produced by mixing raw materials such as a ceramic powder and a binder, then forming a resultant mixture into a sheet shape to prepare a sheet-shaped producing ceramic compact, and sintering a plate-shaped producing ceramic compact obtained by cutting the sheet-shaped producing ceramic compact (the sheet-shaped producing ceramic compact and the plate-shaped producing ceramic compact are also called green sheets). In this production method, for the purpose of sintering many plate-shaped producing ceramic compacts at one time, a plurality of plate-shaped producing ceramic compacts are sintered in a state where they are stacked on top of each other with a release agent being applied thereonto. By applying a release agent onto the surfaces of green sheets, it is possible to prevent resultant ceramic substrates (plate-shaped ceramic sintered compacts) from adhering to each other.

For example, Patent Document 1 discloses a method for obtaining a plate-shaped ceramic sintered compact, that is, a ceramic substrate with reduced surface waviness by sintering a plate-shaped producing ceramic compact including a release agent layer that has a controlled composition and is formed by applying a boron nitride paste onto the surface of a sheet-shaped producing ceramic compact.

Meanwhile, in a conventional process of producing ceramic substrates, offcuts generated by cutting sheet-shaped producing ceramic compacts to a desired size after applying a release agent and sheet-shaped producing ceramic compacts and plate-shaped producing ceramic compacts having a defect, such as a hole, a breakage, or excess or deficiency in the amount of a release agent applied, after applying a release agent are disposed of as offcuts.

The offcuts such as offcuts and defective products of sheet-shaped producing ceramic compacts and plate-shaped producing ceramic compacts are desirably reused as a raw material of ceramic substrates to improve yield and reduce waste. However, it is difficult to completely separate, from the offcuts generated after applying a release agent, the release agent, and when the offcuts are reused, a remaining release agent component causes a reduction in the performance of ceramic substrates. Such a reduction in performance has not been understood on the basis of distribution of the release agent component. These reasons have hindered the reuse of the offcuts generated after applying a release agent.

### PRIOR ART DOCUMENTS

### PATENT DOCUMENT

Patent Document 1: Japanese Patent No. 5673847

### SUMMARY OF THE INVENTION

### PROBLEMS TO BE SOLVED BY THE INVENTION

It is therefore an object of the present invention to provide a ceramic substrate produced in high yield even when containing a release agent component, a ceramic circuit board, a semiconductor device, a method for producing a slurry, and a method for applying a release agent.

### MEANS FOR SOLVING THE PROBLEMS

A ceramic substrate according to an embodiment has a first surface as a front surface and a second surface as a back surface, when a midpoint of a line segment connecting a central portion P1 of the first surface and a central portion P2 of the second surface is defined as a midpoint portion C1, an amount of a component of a release agent measured at the central portion P1 of the first surface or the central portion P2 of the second surface is five times or more an amount of the component of the release agent measured at the midpoint portion C1.

### BRIEF DESCRIPTION OF THE DRAWINGS

FIG. 1 is a schematic sectional view of an example of a ceramic substrate according to an embodiment.
FIG. 2 is a schematic view of an example of a ceramic circuit board according to an embodiment.
FIG. 3 is a schematic view of an example of a semiconductor device.
FIG. 4 is a diagram of an example of a sheet-shaped producing ceramic compact.
FIG. 5 is a diagram showing an example of a cutting step in which the sheet-shaped producing ceramic compact is cut.
FIG. 6 is a flowchart of an example of a method for producing a ceramic sintered compact according to an embodiment.

### DESCRIPTION OF EMBODIMENTS

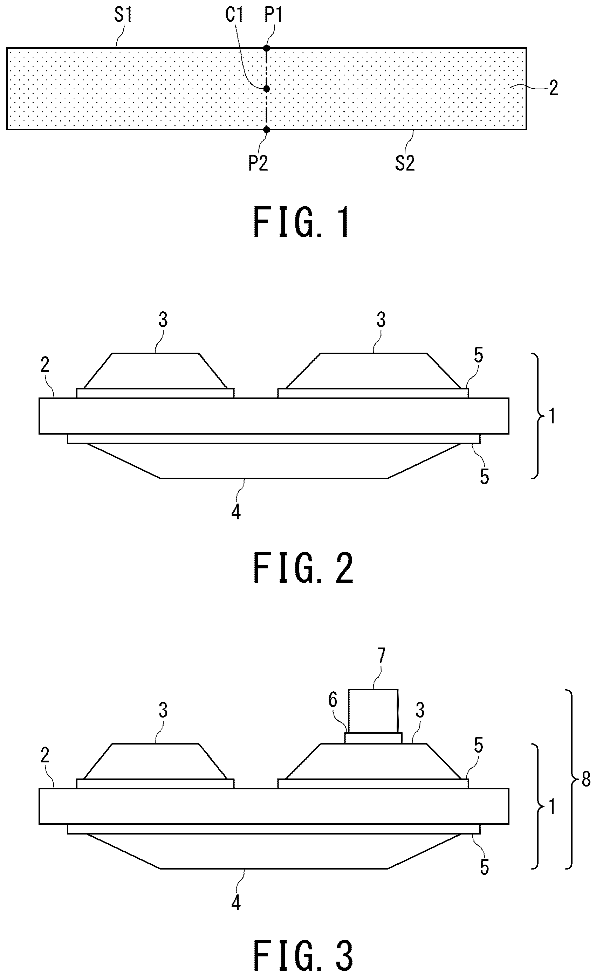

A ceramic substrate, a ceramic circuit board, a semiconductor device, a method for producing a slurry, and a method for applying a release agent according to embodiments will be described with reference to FIG. 1 to FIG. 6.

The ceramic substrate according to the embodiment is suitable for use in a ceramic circuit board and a semiconductor device having a conductive portion bonded thereto.

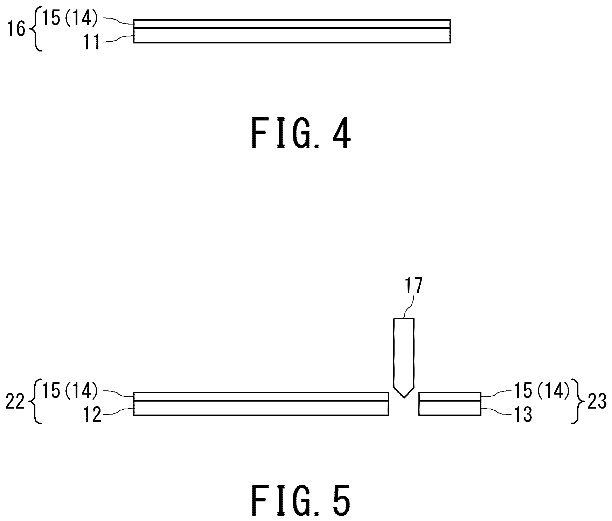

The ceramic substrate, the ceramic circuit board, and the semiconductor device according to the embodiments will be described with reference to FIG. 1 to FIG. 6. FIG. 1 is a schematic view of section (surface orthogonal to front and back surfaces) of an example of a ceramic substrate onto which a release agent has been applied. In the ceramic substrate according to the embodiment, reference sign S1 denotes a first surface (front surface). The center of the first surface S1 is defined as a central portion P1. Reference sign S2 denotes a second surface (back surface). The center of the second surface S2 is defined as a central portion P2. FIG. 2 shows a ceramic circuit board in which a front copper plate and a back copper plate are disposed on both of the surfaces of the ceramic substrate with a bonding layer being interposed between them. FIG. 3 shows a semiconductor device. FIG. 4 shows an example of a sheet-shaped producing ceramic compact. FIG. 5 shows an example of a cutting step in which the sheet-shaped producing ceramic compact is cut.

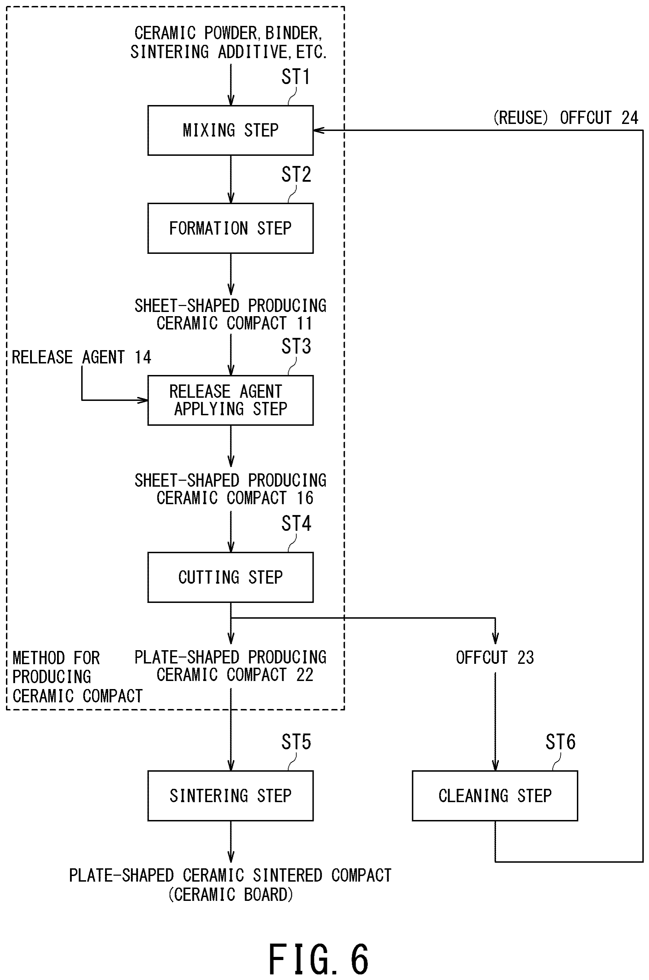

FIG. 6 shows a method for producing a ceramic sintered compact according to the embodiment. In FIG. 6, reference sign ST1 denotes a mixing step, reference sign ST2 denotes a forming step, reference sign ST3 denotes a release agent applying step, reference sign ST4 denotes a cutting step, reference sign ST5 denotes a sintering step, and reference sign ST6 denotes a cleaning step.

In the diagrams, reference sign 1 denotes a ceramic circuit board (e.g., a ceramic copper circuit board), reference sign 2 denotes a ceramic substrate, reference sign 3 denotes a copper plate (front copper plate) as a conductive portion, reference sign 4 denotes a copper plate (back copper plate) as a conductive portion, reference sign 5 denotes a bonding layer (active metal brazing material layer), reference sign 6 denotes a bonding layer between a copper plate and a semiconductor element, reference sign 7 denotes a semiconductor element, reference sign 8 denotes a semiconductor device, reference sign 11 denotes a sheet-shaped producing ceramic compact not containing a release agent (bed powder) applied, reference sign 12 denotes a plate-shaped producing ceramic compact not containing a release agent (bed powder) applied, reference sign 13 denotes an offcut not containing a release agent (bed powder) applied, reference sign 14 denotes a release agent, reference sign 15 denotes a release agent layer, reference sign 16 denotes a sheet-shaped producing ceramic compact including the sheet-shaped producing ceramic compact 11 and a release agent applied thereonto, reference sign 17 denotes a cutting jig, reference sign 22 denotes a plate-shaped producing ceramic compact including the plate-shaped producing ceramic compact 12 and a release agent applied thereonto, reference sign 23 denotes an offcut before cleaning, and reference sign 24 denotes an offcut after cleaning.

The ceramic circuit board 1 shown in FIG. 2 has a structure in which the copper plate 3 on one of the front and back surfaces has a circuit pattern, and the copper plate 4 on the other surface serves as a heat dissipation plate. For the sake of convenience, the copper plate 3 is referred to as a front copper plate and the copper plate 4 is referred to as a back copper plate. In the ceramic circuit board 1 shown in FIG. 2, two front copper plates 3 are disposed on the ceramic substrate 2. The ceramic circuit board 1 according to the embodiment is not limited to one having such a form, and may have a structure in which three or more front copper plates 3 are provided on the ceramic substrate 2 or a structure in which one front copper plate 3 is provided on the ceramic substrate 2. Alternatively, the ceramic circuit board 1 according to the embodiment may have a structure in which the back copper plate 4 has a circuit pattern. Alternatively, the ceramic circuit board 1 according to the embodiment may have a structure in which only the front copper plate 3 is provided without providing the back copper plate 4 on the ceramic substrate 2.

In the semiconductor device 8 shown in FIG. 3, the semiconductor element 7 is provided only in one position. However, the semiconductor device 8 according to the embodiment is not limited to one having such a form, and the semiconductor element 7 may be provided in two or more positions. On the front copper plate 3 as one circuit portion, two or more semiconductor elements 7 may be provided.

FIG. 2 and FIG. 3 respectively show the ceramic circuit board 1 and the semiconductor device 8 in which copper plates are disposed on both surfaces of the ceramic substrate 2, but the ceramic circuit board 1 and the semiconductor device 8 according to the embodiments are not limited to those having such a form. For example, an aluminum plate may be disposed instead of the back copper plate 4 as a heat dissipation plate. Further, the ceramic circuit board 1 and the semiconductor device 8 respectively shown in FIG. 2 and FIG. 3 have bonding layers, but the ceramic circuit board 1 and the semiconductor device 8 according to the embodiments are not limited to those having such a form and may have or lack (in the case of direct bonding) the bonding layer 6.

The thickness of the ceramic substrate 2 according to the embodiment is preferably 0.1 mm or more and 3 mm or less. If the thickness of the ceramic substrate 2 is less than 0.1 mm, there is a fear that the ceramic substrate 2 is poor in strength. On the other hand, if the thickness of the ceramic substrate 2 is larger than 3 mm, there is a possibility that the ceramic substrate 2 becomes a thermal resistor so that the heat dissipation performance of the ceramic circuit board 1 reduces. More preferably, the thickness of the ceramic substrate 2 is 0.15 mm or more and 2 mm or less.

The shape of the front and back surfaces of the ceramic substrate 2 according to the embodiment is not limited and may be, for example, a rectangular (including square) shape or an almost circular shape. When the front and back surfaces of the ceramic substrate 2 have a rectangular shape, the central portions P1 and P2 are points of intersection between two diagonal lines. When the front and back surfaces of the ceramic substrate 2 have a circular shape, the central portions P1 and P2 are centers of the circles. In either case, the major-axis length or the diameter is preferably 100 mm or more.

Specific examples of material of the ceramic substrate 2 include a silicon nitride substrate, an aluminum nitride substrate, an aluminum oxide substrate, and an aluzir substrate.

The silicon nitride substrate preferably has a three-point bending strength of 600 MPa or more. An increase in the strength of the substrate can reduce the thickness of the substrate. Therefore, the three-point bending strength of the silicon nitride substrate is preferably 600 MPa or more, more preferably 700 MPa or more. The silicon nitride substrate can have a reduced substrate thickness of 0.40 mm or less or 0.30 mm or less. The silicon nitride substrate preferably has a thermal conductivity of 80 W/m·K or more. The silicon nitride substrate having a thermal conductivity of 80 W/m·K or more may be, for example, one having a thermal conductivity of 90 W/m·K or 130 W/m·k.

The aluminum nitride substrate generally has a three-point bending strength of about 300 to 450 MPa. On the other hand, the aluminum nitride substrate generally has a thermal conductivity of 160 W/m·K or more. The aluminum nitride substrate has low strength and therefore preferably has a substrate thickness of 0.60 mm or more.

The aluminum oxide substrate generally has a three-point bending strength of about 300 to 450 MPa but is inexpensive. The aluzir substrate generally has a high three-point bending strength of about 550 MPa but has a thermal conductivity of about 30 to 50 W/m·K. It should be noted that the aluzir substrate refers to a substrate formed of a sintered compact of a mixture of aluminum oxide and zirconium oxide.

The ceramic substrate 2 according to the embodiment is more preferably a nitride-based ceramic. Among nitride-based ceramics, from the viewpoint of thermal properties and mechanical properties, the ceramic substrate 2 is more preferably either a silicon nitride substrate or an aluminum nitride substrate. When a metallic member is bonded to the ceramic substrate using an active metal brazing material, a reaction product that contributes to bonding strength is formed at an interface between the nitride-based ceramic and the brazing material. For example, when an active metal brazing material containing Ti is used for bonding, the nitride-based ceramic reacts with Ti contained in the brazing material to form titanium nitride. Such a reaction product strengthens bonding, and therefore bonding strength with a metallic member, especially with a copper plate can be increased.

The ceramic substrate 2 according to the embodiment contains a component of the release agent 14. The release agent 14 contained in the ceramic substrate 2 is one applied onto the sheet-shaped producing ceramic compact 11 in the release agent applying step ST3 (shown in FIG. 6) before sintering or one derived from the offcuts 24 as a raw material of a recycled slurry that will be described later. The amount of the component of the release agent 14 at the central portion P1 or the central portion P2 of the ceramic substrate 2 according to the embodiment is preferably five times or more the amount of the component of the release agent 14 at a midpoint portion C1 that is a midpoint of a line segment connecting the central portion P1 and the central portion P2. In addition to the above, it is more preferred that a ratio P1/P2 between the amount of the component of the release agent 14 at the central portion P1 and the amount of the component of the release agent 14 at the central portion P2 satisfies 0.5 ≤ P1/P2 ≤ 2. Further, in addition to the above, it is more preferred that the amount of the component of the release agent 14 at the midpoint portion C1 is more than 0 ppm by mass and 50 ppm by mass or less. By controlling the component of the release agent 14 contained in the ceramic substrate 2 to satisfy the above requirements, excellent dielectric strength and mechanical properties are exhibited. The amount of the component of the release agent 14 at the central portion P1 or the central portion P2 can be controlled by adjusting the amount of the release agent 14 applied onto the sheet-shaped producing ceramic compact 11 that will be described later in the process of producing the ceramic substrate 2. Further, the amount of the component of the release agent 14 at the midpoint portion C1 can be controlled by adjusting the degree of cleaning of the offcuts 23 generated after applying the release agent 14 onto the sheet-shaped producing ceramic compact 11 or the amount of the offcuts 24 after cleaning added to a slurry in the method for producing a slurry that will be described later.

It should be noted that the raw material composition of the ceramic substrate 2 may include, as an auxiliary agent, a component that is the same as the component of the release agent 14, but when the amount of the component measured at the midpoint portion C1 is sufficiently small, for example, 300 ppm by mass or less, the component exhibits substantially no effect as an auxiliary agent, and therefore the component is all regarded as the component of the release agent 14.

When the ceramic substrate 2 is used for the ceramic circuit board 1, at least one conductive portion is preferably disposed on both or one of the front and back surfaces of the ceramic substrate 2. The ceramic circuit board 1 according to the embodiment may be one in which the conductive portion is directly disposed on the ceramic substrate 2 or one in which the conductive portion is disposed on the ceramic substrate 2 with the brazing material layer 5 being interposed between them. The ceramic circuit board 1 according to the embodiment may be one obtained by bonding a conductive portion having a circuit pattern previously formed by cutting or die-cutting or one obtained by bonding a conductive portion and then etching the conductive portion to form a circuit pattern. When conductive portions are disposed on the front and back surfaces of the ceramic substrate 2, the thickness of the conductive portion disposed on the front surface and the thickness of the conductive portion disposed on the back surface may be the same or different.

The conductive portion of the circuit board 1 according to the embodiment is preferably made of at least one selected from among copper, a copper alloy, aluminum, and an aluminum alloy. More preferably, the conductive portion is made of copper or a copper alloy. Copper or a copper alloy is superior in thermal conductivity to aluminum or an aluminum alloy. Generally, copper has a high thermal conductivity of about 400 W/m·k, and therefore heat dissipation performance of the ceramic circuit board 1 can be improved. The conductive portion made of copper or a copper alloy is more preferably one made of oxygen-free copper or one in which a graphite layer is present in a copper layer. Aluminum or an aluminum alloy is cheaper than copper and is therefore preferred when cost is regarded as important.

When the conductive portion is made of copper or a copper alloy, the thickness of the conductive portion may be 0.3 mm or more or 0.6 mm or more. The conductive portion made of copper or a copper alloy and having a thickness of 0.6 mm or more may be, for example, a copper plate having a thickness of 1 mm or a copper plate having a thickness of 2 mm. An increase in the thickness of the conductive portion makes it possible to improve the heat dissipation performance of a bonded compact.

As described above, the ceramic circuit board 1 according to the embodiment is preferably a ceramic copper circuit board. The ceramic copper circuit board herein refers to a circuit board having, as a circuit, a conductive portion made of copper or a copper alloy.

The ceramic circuit board 1 according to the embodiment may have a heat dissipation member as a conductive portion. The heat dissipation member may extend beyond the ceramic substrate (e.g., a heat dissipation plate and a lead frame may be integrated) or may have a grooved shape. Further, the heat dissipation member may have a recessed portion in the surface thereof.

When the ceramic circuit board 1 according to the embodiment has a brazing material, the type of brazing material forming the brazing material layer 5 may be changed depending on the type of ceramic constituting the ceramic circuit board 1 or the type of the conductive portion. For example, when the type of the ceramic is a nitride-based ceramic and the conductive portion is made of copper or a copper alloy, the brazing material preferably contains at least one selected from among silver, copper, and an active metal. The active metal is more preferably at least one metallic species selected from among Ti, Zr, Nb, and Hf. The brazing material to be used may be one made of only two metallic components (except for inevitable impurities), such as an Al-Ti alloy, a Cu-Mg alloy, a Cu-Ti alloy, or an Ag-Ti alloy, or one made of three or more metallic components (except for inevitable impurities), such as an Ag-Cu-Ti alloy, a Cu-Sn (or In or Mn)-Ti alloy, or an Ag-Cu-Sn (or In or Mn)-Ti alloy. It should be noted that "Sn (or In or Mn)" herein refers to at least one metallic species selected from among three species of Sn, In, and Mn.

Particularly, among the above-described brazing material compositions, one containing an active metal is more preferred. Even more preferably, one or more of Ag (silver) and Cu (copper) are contained in a total amount of 50 wt% or more and 99 wt% or less. Still even more preferably, Sn (or In or Mn) is contained in a ratio of 0.5 wt% or more and 35 wt% or less. Still even more preferably, the active metal is contained in a total amount of 0.5 wt% or more and 25 wt% or less.

The thickness of the brazing material layer 5 is preferably 5 µm or more and 45 µm or less. More preferably, the thickness of the brazing material layer 5 is 10 µm or more and 25 µm or less. If the thickness of the brazing material layer 5 is as small as less than 5 µm, there is a fear that sufficient strength is not maintained. On the other hand, if the thickness of the brazing material layer 5 is as thick as more than 45 µm, there is a fear that a problem caused by a difference in thermal expansion coefficient between the ceramic substrate 2 and the bonding layer 6 occurs, such as cracking at a bonding interface or warpage of the ceramic circuit board 1.

The brazing material layer 5 is formed by bonding the ceramic substrate 2 and the conductive portion by brazing. When the ceramic substate 2 and the conductive portion are brazed, for example, a brazing material paste or a brazing material foil may be used. When a brazing material paste is used, the brazing material paste may be applied multiple times. In this case, the composition of the brazing material paste may be changed.

In the semiconductor device 8 according to the embodiment, the semiconductor element 7 is provided on the conductive portion of the circuit board 1 according to the embodiment by, for example, interposing the bonding layer 6 between them. The bonding layer 6 is formed by bonding the conductive portion and the semiconductor element 7 with, for example, a solder material or an electrically conductive adhesive. When the conductive portion and the semiconductor element 7 are bonded with an electrically conductive adhesive, the electrically conductive adhesive may be, for example, a silver paste mainly containing silver or a copper paste mainly containing copper. The silver paste is preferred because it is less likely to oxidize. The copper paste is cheaper than the silver paste and is therefore preferred when cost is regarded as important.

Examples of the semiconductor element 7 include a silicon carbide (SiC) power semiconductor and a gallium nitride (GaN) power semiconductor.

The method for producing a slurry according to the embodiment will be described.

The method for producing a slurry according to the embodiment includes a cleaning step ST6 (shown in FIG. 6) in which offcuts 23 obtained by cutting sheet-shaped producing ceramic compact 16 onto which a release agent 14 has been applied are cleaned and a mixing step ST1 in which offcuts 24, from which part of the release agent 14 has been separated in the cleaning step ST6, are added to and mixed with a fresh slurry composed of a ceramic powder, a binder, a sintering aid, etc. to obtain a recycled slurry.

First, offcuts 23 are prepared which are obtained by cutting sheet-shaped producing ceramic compacts 16 onto which a release agent 14 has been applied. The offcuts 23 are produced through steps ST1 to ST4. It should be noted that the offcuts 23 prepared here may be those produced without adding a reused raw material such as offcuts 24 in the mixing step ST1, that is, those produced only from a fresh slurry.

In the mixing step ST1 (shown in FIG. 6), a ceramic powder, a binder, a sintering aid, etc. are mixed to obtain a slurry. The ceramic powder may be a powder mainly containing one selected from among silicon nitride, aluminum nitride, aluminum oxide, zirconium oxide, and silicon carbide. The type of the ceramic powder is selected depending on the main component of a desired ceramic substrate (plate-shaped ceramic sintered compact). Here, the main component of a sheet-shaped producing ceramic compact 11, a plate-shaped producing ceramic compact 22, or a plate-shaped ceramic sintered compact produced by sintering it refers to a component having the highest mass ratio among components constituting the sheet-shaped producing ceramic compact 11, the plate-shaped producing ceramic compact 22, or the plate-shaped ceramic sintered compact. When a sheet-shaped producing ceramic compact 11 containing silicon nitride as a main component is sintered, a silicon nitride sintered compact is obtained. When a sheet-shaped producing ceramic compact 11 containing aluminum oxide as a main component is sintered, an aluminum oxide sintered compact is obtained.

In the forming step ST2 (shown in FIG. 6), a sheet-shaped producing ceramic compact 11 is formed from the slurry by a doctor blade method, die pressing, cold isostatic pressing (CIP), injection molding, or the like. When a ceramic substrate is produced, a doctor blade method is preferred. The use of a doctor blade method makes it possible to produce a long sheet-shaped producing ceramic compact 11. This makes it possible to improve the mass productivity of a ceramic substrate (plate-shaped ceramic sintered compact). Hereinbelow, a description will be made with reference to a case where a sheet-shaped producing ceramic compact 11 is obtained by a doctor blade method.

In the forming step ST2 (shown in FIG. 6), the sheet-shaped producing ceramic compact 11 is subjected to degreasing treatment, if necessary. A degreased compact obtained by subjecting the sheet-shaped producing ceramic compact 11 to degreasing treatment is also regarded as a sheet-shaped producing ceramic compact 11. It should be noted that the degreasing treatment may be performed on a sheet-shaped producing ceramic compact 11 in the forming step ST2 before applying a release agent 14 or may be performed on a sheet-shaped producing ceramic compact 16 after applying a release agent 14 or may be performed on a plate-shaped producing ceramic compact 22 after performing cutting. A degreased compact obtained by subjecting the sheet-shaped producing producing ceramic compact 16 to degreasing treatment is also regarded as a sheet-shaped producing ceramic compact 16, and a degreased compact obtained by subjecting the plate-shaped producing ceramic compact 22 to degreasing treatment is also regarded as a plate-shaped producing ceramic compact 22.

Then, in the release agent applying step ST3 (shown in FIG. 6), a release agent 14 is applied onto the sheet-shaped producing ceramic compact 11 to provide a release agent layer 15. Examples of a method for applying the release agent 14 onto the sheet-shaped producing ceramic compact 11 include a method using a spray, a method in which the sheet-shaped producing ceramic compact 11 is dipped in a solution containing a bed powder 4, a method using a brush, a method using static electricity, a method using gravure printing, and a method in which the sheet-shaped producing ceramic compact 11 is immersed in a solution containing a bed powder 4. Then, in the cutting step ST4 (shown in FIG. 6), a sheet-shaped producing ceramic compact 16 to which the release agent 14 has been attached is cut to a desired size.

It should be noted that in the process of producing the ceramic substrate 2, the sheet-shaped producing ceramic compact 16 is generally cut into pieces having a desired size using, for example, a cutting jig 17 (shown in FIG. 5). Here, a formed compact before such release agent application and such cutting is referred to as a sheet-shaped producing ceramic compact 11 (shown in FIG. 4), a formed compact before cutting obtained by applying a release agent 14 onto the sheet-shaped producing ceramic compact 11 is referred to as a sheet-shaped producing ceramic compact 16 (shown in FIG. 4), and each formed compact obtained by cutting the sheet-shaped producing ceramic compact 16 is referred to as a plate-shaped producing ceramic compact 22 (shown in FIG. 5). The sheet-shaped producing ceramic compact 16 is obtained by applying a release agent 14 onto a sheet-shaped producing ceramic compact 11 to form a release agent layer 15 on the sheet-shaped producing ceramic compact 11. The plate-shaped producing ceramic compact 22 includes a plate-shaped producing ceramic compact 12 and a release agent layer 15 formed on the plate-shaped producing ceramic compact 12.

Here, the offcut 23 refers to an offcut generated by cutting the sheet-shaped producing ceramic compact 16 to a desired size. Also the offcut 23 refers to an unwanted article having a defect such as a hole, a breakage, excess or deficiency in thickness, or excess or deficiency in the amount of a release agent applied. Also, the offcut 23 refers to the sheet-shaped producing ceramic compact 16, the plate-shaped producing ceramic compact 22, or part of the sheet-shaped producing ceramic compact 16 or the plate-shaped producing ceramic compact 22 obtained as a cutting or the like to be reused as a slurry raw material. Hereinafter, an offcut generated from the sheet-shaped producing ceramic compact 16 or the plate-shaped producing ceramic compact 22 onto which the release agent 14 has been applied is sometimes simply referred to as an "offcut".

In this embodiment, the release agent 14 is, for example, one or more selected from among boron nitride, zirconium oxide, aluminum oxide, and aluminum nitride. The release agent 14 plays a role in preventing plate-shaped producing ceramic compacts 22 from adhering to each other when the plate-shaped producing ceramic compacts 22 are sintered in a state where they are stacked on top of each other. The release agent 14 preferably has an average particle diameter of 20 µm or less. If the average particle diameter is as large as more than 20 µm, there is a fear that the amount of the release agent 14 applied is non-uniform so that the surface property of a sintered compact is adversely affected. The average particle diameter of the release agent 14 is more preferably 10 µm or less, even more preferably 6 µm or less. The lower limit of the average particle diameter of the release agent 14 is not limited but is preferably 2 µm or more. If the average particle diameter is less than 2 µm, there is a possibility that handleability is poor.

Then, the cleaning step is performed in which the release agent 14 is separated from the offcuts 23 by cleaning to collect offcuts 24 from which part of the release agent 14 has been separated.

Before cleaned, the offcuts 23 are preferably made uniform in size. Therefore, when being different in size, the offcuts 23 are preferably cut so as to have almost the same size. It should be noted that "almost the same" herein means that the average of the areas of front and back surfaces of the offcuts 23 is 1/3 or more of the maximum value among the areas. When the areas of front and back surfaces of the offcuts 23 are closer to each other, uneven removal of the release agent 14 is less likely to occur. Further, when the offcuts 23 are reused as a slurry raw material, the component of the release agent 14 is likely to be uniformly dispersed in a slurry, and therefore even when the amount of the component of the release agent 14 attached to each of the offcuts 23 is about 50 ppm by mass, the offcuts 23 can be reused without problem.

The areas of front and back surfaces of each of the offcuts 23 are preferably 2 cm² or more. If each of the offcuts 23 has a small shape such that the areas of front and back surfaces thereof are less than 2 cm², there is a fear that the amount of a cleaning liquid attached to the offcuts 23 is increased so that it takes time to dry them. The upper limit of the areas of front and back surfaces of each of the offcuts 23 are not limited but are preferably 100 cm² or less to increase cleaning efficiency. It should be noted that when the offcuts 23 do not have a sheet shape or a plate shape, an appropriate scale such as a surface area or an apparent surface area may be used instead of the areas of the front and hack surfaces.

In the cleaning step ST6 (shown in FIG. 6), the offcuts 23 are preferably cleaned by ultrasonic cleaning. The use of ultrasonic cleaning improves the effect of cleaning, which makes it possible to reduce cleaning time and the number of times of cleaning. The temperature of a cleaning liquid used for cleaning the offcuts 23 is preferably 5°C or higher and 60°C or lower. When the temperature of the cleaning liquid is 5°C or higher, the efficiency of drying after cleaning can be improved. On the other hand, when the temperature of the cleaning liquid is 60°C or lower, the binder is less likely to be denatured. More preferably, the temperature of the cleaning liquid is 15°C or higher and 40°C or lower.

The cleaning liquid to be used for cleaning the offcuts 23 is not limited, but is preferably a solution obtained by adding a water-soluble auxiliary agent to water as a solvent. Examples of the water-soluble auxiliary agent include an organic compound having a hydrophilic group, such as a carboxyl group, an alcohol group, an amino group, a thiol group, a sulfo group, a phosphate group, or a ketone group, and a salt thereof. Two or more cleaning liquids may be used to clean the offcuts 23.

A surfactant may be added to the cleaning liquid to be used for cleaning the offcuts 23 to prevent the component of the release agent 14 from being again attached to the offcuts 23. The surfactant to be added may either be a nonionic surfactant or an ionic surfactant. When an ionic surfactant is added, any one of an anionic surfactant, a cationic surfactant, and an amphoteric surfactant may be used, but an amphoteric surfactant is preferably used.

When an anionic surfactant or a cationic surfactant remains on offcuts 24 after cleaning, which will be described later, and such offcuts 24 are used as a slurry raw material, there is a fear that the sinterability of a plate-shaped producing ceramic compact 22 obtained by forming is affected.

Examples of the anionic surfactant include a carboxylic acid-type surfactant, a sulfonic acid-type surfactant, a sulfuric acid ester-type surfactant, and a phosphoric acid ester-type surfactant. Examples of the cationic surfactant include an alkylamine salt-type surfactant and a quaternary ammonium salt-type surfactant. Examples of the amphoteric surfactant include a carboxybetaine-type surfactant, a 2-alkylimidazoline derivative-type surfactant, a glycine-type surfactant, and an amine oxide-type surfactant. The surfactant to be used is preferably a nonionic surfactant. Examples of the nonionic surfactant include an ester-type surfactant, an ether-type surfactant, an ester ether-type surfactant, and an alkanol amide-type surfactant. When a nonionic surfactant is used, a polyhydric alcohol-based surfactant may be used or a polyoxyethylene-based surfactant may be used. When the surfactant to be used is a nonionic surfactant, the surfactant does not remain as ions on the offcuts 24 after cleaning. Therefore, when the offcuts 24 are reused, a reduction in sinterability can be prevented.

As described above, the cleaning liquid used for cleaning the offcuts 23 is one obtained by adding a water-soluble auxiliary agent to water as a solvent. The water-soluble auxiliary agent particularly preferably contains, as a main component, an amphoteric surfactant or a nonionic surfactant composed of three or more selected from among carbon (C), hydrogen (H), oxygen (O), and nitrogen (N) and containing no other atom. When the offcuts 24 after cleaning are used as a slurry raw material, such a surfactant is less likely to affect sinterability even in a case where it remains on the offcuts 24 after cleaning and is therefore mixed into a slurry.

Further, when the surfactant has a straight chain portion, the number of carbon atoms in the straight chain portion is preferably 25 or less. When the number of carbon atoms in the straight chain portion is small, it is possible to prevent the binder contained in the offcuts 23 from being dissolved in the cleaning liquid. On the other hand, if the number of carbon atoms is too large, there is a fear that the surfactant is not sufficiently dissolved in the cleaning liquid, and therefore it is difficult to separate the component of the release agent 14 from the offcuts 23. By controlling the number of carbon atoms, the component of the release agent 14 is easily separated from the offcuts 23.

The cleaning liquid may be an inorganic compound solution. The inorganic compound solution may be a solution containing, as a solute, a gas such as carbonic acid, nitrogen, oxygen, or argon. When a gas is used, it can be expected that the effect of removing the component of the release agent 14 attached to the offcuts 23 is obtained when bubbles composed of the gas burst in water. Further, when the gas component is used, it is more preferred that the temperature of the cleaning liquid is controlled to be 5°C or higher. When the temperature of the cleaning liquid is 5°C or higher, the degree of dissolution of the gas component in water is sufficiently increased so that variations in the effect of cleaning can be reduced.

The number of times of cleaning the offcuts 23 and the amount of the auxiliary agent added to the cleaning liquid may freely be selected depending on the purpose. Therefore, the number of times of cleaning the offcuts 23 and the amount of the added auxiliary agent are not limited. The offcuts 24 after cleaning may be taken out from the cleaning liquid at once using a strainer or the like or may be taken out one by one. When a strainer-like tool is used to take out the offcuts 24, the tool preferably has an opening size such that the cleaning liquid and the release agent 14 can sufficiently pass through it.

A solution containing the release agent 14 generated by cleaning the offcuts 23 in the cleaning step ST6 (shown in FIG. 6) may be subjected to separation between the component of the release agent 14 and a solution component by, for example, a method in which the solution is left to stand to precipitate the component of the release agent 14 or a method in which the solution is subjected to filtration or centrifugation to reuse the solution component as a cleaning liquid. The component of the release agent 14 separated from the offcuts 23 may be used again as the release agent 14 to be applied onto a new sheet-shaped producing ceramic compact 11. Alternatively, a solution for applying the release agent 14 may be prepared by adjusting the contents of the component of the release agent 14 and other components.

Then, the mixing step ST1 (shown in FIG. 6) is performed in which the offcuts 24 after cleaning are added to and mixed with a fresh slurry to obtain a recycled slurry. When the offcuts 24 after cleaning are added to a fresh slurry, the amount of the added offcuts 24 after cleaning is preferably 25% by mass or less relative to 100% by mass of a powder raw material of the fresh slurry. More preferably, the amount of the added offcuts 24 after cleaning is 5% by mass or more and 20% by mass or less. If the amount of the added offcuts 24 after cleaning is less than 5% by mass relative to 100% by mass of a powder raw material of the slurry, there is a fear that the advantages of reuse cannot sufficiently be obtained. On the other hand, if the amount of the added offcuts 24 after cleaning exceeds 25% by mass, there is a fear that cleaning needs to more carefully be performed by, for example, increasing the number of times of cleaning so that the cost of cleaning increases.

When the offcuts 24 are added to a fresh slurry, wet mixing is preferably performed using a bead mill, a ball mill, or the like. When the wet mixing is performed, a binder component is preferably added in a predetermined amount larger than usual. Alternatively, after a binder component is added in a predetermined amount as described above, a solvent is preferably added to achieve a predetermined viscosity.

The component ratio of the offcuts 24 after cleaning is different from a component ratio desirable for a slurry due to, for example, volatilization during production. Adjusting a binder component and a solvent component in such a manner as described above can compensate for the lack of the components caused by adding the offcuts 24 after cleaning to obtain a recycled slurry having a desirable component ratio. When the mixing is performed, sheet-shaped producing ceramic compacts 11 regarded as defective due to, for example, cracks or excess or deficiency in thickness in a drying step or the like before applying the release agent 14 may also be added. As described above, when sheet-shaped producing ceramic compacts 11 before applying the component of the release agent 14 are further mixed, the number of ceramic sintered compacts that can be produced per the same amount of a raw material powder can be increased, which makes it possible to further increase yield for the same amounts of raw materials. In this case, the total amount of the offcuts 24 after cleaning added and the sheet-shaped producing ceramic compact 11 before applying the release agent 14 added is preferably 25% by mass or less relative to 100% by mass of a powder raw material of the slurry. More preferably, the total amount is 5% by mass or more and 20% by mass or less.

When a slurry for ceramic sintered compacts using alumina as a raw material is produced by the method according to the embodiment using alumina sintered compacts as a medium in a bead mill or a ball mill, the amount of alumina added as a raw material may be controlled in consideration of alumina mixed into the slurry due to abrasion of the medium.

It should be noted that after the fresh slurry is subjected to the steps ST1 to ST4 or the recycled slurry (based on the offcuts 24) is subjected to the steps ST1 to ST4, plate-shaped producing ceramic compacts 22 are sintered in the sintering step ST5 (shown in FIG. 6) to produce plate-shaped ceramic sintered compacts, that is, ceramic substrates. In the sintering step ST5, sintering is usually performed by heat treatment under ordinary pressure or increased pressure at 1600 to 2000°C. In the sintering step ST5, heat treatment may be performed in two stages by changing the temperature range thereof.

It should be noted that in the release agent applying step ST3 (shown in FIG. 6), a reused release agent 14 may be applied. In this case, a method for applying a release agent component includes, for example, the cleaning step ST6 in which the offcuts 23 are cleaned to obtain ceramic sintered compact pieces from which part of the release agent 14 has been separated, an adjusting step in which a solution containing the release agent 14 is prepared by adjusting the content of the separated release agent 14 in the solution, a dispersing step in which the concentration of the release agent 14 contained in the solution adjusted in the adjusting step is uniformly dispersed, and an applying step in which the solution subjected to the dispersing step is applied onto a sheet-shaped producing ceramic compact 11. The release agent applying step ST3 includes, for example, the applying step in which the solution subjected to the dispersing step is applied onto a sheet-shaped producing ceramic compact 11. In the applying step, the release agent 14 is preferably attached to the sheet-shaped producing ceramic compact 11 by a spray method. The use of a spray method makes it possible to stabilize the amount of the release agent 14 sprayed. Further, when a plurality of spray nozzles are provided, the release agent 14 can be applied onto a large area. Further, when a spray method is used, the release agent 14 can also be applied onto a long sheet-shaped producing ceramic compact 11 while the long sheet-shaped producing ceramic compact 11 is transferred. In the case of a spray method, a solution containing the release agent 14 may be sprayed.

### (Examples)

A sheet-shaped producing ceramic compact 11 containing, as a main component, silicon nitride or aluminum nitride was prepared, and boron nitride was applied thereonto as a release agent 14. Then, a sheet-shaped producing ceramic compact 16 after applying the release agent 14 was cut to produce, as simulated offcuts 23, plate-shaped producing ceramic compacts (hereinafter referred to as "ceramic compact pieces") whose areas of front and back surfaces were smaller than 15 cm². Then, in a cleaning step ST6 (shown in FIG. 6), the ceramic compact pieces were cleaned using a first cleaning liquid (cleaning liquid 1), a second cleaning liquid (cleaning liquid 2), and a third cleaning liquid (cleaning liquid 3). The material of the sheet-shaped producing ceramic compact 11 cut to produce ceramic compact pieces according to each of Examples 1 to 5 and Comparative Examples 1 and 2, the cause of defect of the ceramic compact pieces, and a method for cleaning the ceramic compact pieces are shown in Table 1.

The composition formula written in the column "Sheet" in Table 1 indicates, as the type of ceramic substrate after sintering, the type of material of the sheet-shaped producing ceramic compact 11 cut to produce ceramic compact pieces according to each of Examples 1 to 5 and Comparative Examples 1 and 2. Here, Si₃N₄ means that the ceramic substrate contains silicon nitride as a main component (50% by mass or more), and similarly, AlN means that the ceramic substrate contains aluminum nitride as a main component (50% by mass or more).

The term "small" written in the column "Cause of defect" in Table 1 means that the ceramic compact pieces are normal in the amount of the release agent 14 applied and have no shape defect but are smaller than the required size. The term "crack" written in the column of "Cause of defect" in Table 1 means that the ceramic compact pieces are normal in the amount of the release agent 14 applied and size but have shape defects (cracks, breakages, or holes). The term "non-uniform" written in the column "Cause of defect" in Table 1 means that the ceramic compact pieces are normal in size and have no shape defect but are regarded as defective in terms of the amount of the release agent 14 applied because the amount of the release agent 14 applied is too non-uniform or the amount of the release agent 14 applied on one of the surfaces is too small.

The terms "cleaning 1", "cleaning 2", and "cleaning 3" written as the contents of a first cleaning step and a second cleaning step in Table 1 respectively refer to rough cleaning, main cleaning, and final cleaning. The rough cleaning, main cleaning, and final cleaning respectively used different cleaning liquids.

In Example 1 and Example 3, cleaning was all performed by ultrasonic cleaning. On the other hand, in Examples 2, 4, and 5 and Comparative Examples 1 and 2, ultrasonic cleaning was not performed.

**[Table 1]**

| | Sheet | Cause of Defect | First Washing Step | | |
|---|---|---|---|---|---|
| | | | Washing 1 | Washing 2 | Washing 3 |
| Example 1 | Si₃N₄ | Smaller | Executed | Executed | Executed |
| Example 2 | Si₃N₄ | Crack | Executed | Executed | Executed |
| Example 3 | Si₃N₄ | Non-Uniform | Executed | Executed | Executed |
| Example 4 | Si₃N₄ | Non-Uniform | Executed | Executed | Executed |
| Example 5 | AlN | Smaller | Executed | Executed | Executed |
| Comparative Example 1 | Si₃N₄ | Crack | Non-Executed | Non-Executed | Non-Executed |
| Comparative Example 2 | Si₃N₄ | Crack | Executed | Executed | Non-Executed |

| | Second Washing Step | | |
|---|---|---|---|
| | Washing 1 | Washing 2 | Washing 3 |
| Example 1 | Executed | Executed | Executed |
| Example 2 | Executed | Executed | Executed |
| Example 3 | Non-Executed | Non-Executed | Executed |
| Example 4 | Non-Executed | Non-Executed | Non-Executed |
| Example 5 | Non-Executed | Non-Executed | Non-Executed |
| Comparative Example 1 | Non-Executed | Non-Executed | Non-Executed |
| Comparative Example 2 | Non-Executed | Non-Executed | Non-Executed |

Then, the amount of the release agent 14 attached to the surface of the ceramic compact pieces was measured before and after the cleaning step.

When the amount (ratio) of the release agent 14 attached to the surface after cleaning was more than 0 ppm by mass and 25 ppm by mass or less, the ceramic compact pieces were evaluated as "A", when the amount (ratio) of the release agent 14 attached to the surface after cleaning was more than 25 ppm by mass and 50 ppm by mass or less, the ceramic compact pieces were evaluated as "B", and when the amount (ratio) of the release agent 14 attached to the surface after cleaning was more than 50 ppm by mass, the ceramic compact pieces were evaluated as "D". The results are shown in Table 2.

Then, a comparison was made between the amount of the release agent 14 attached to the surface before cleaning and the amount of the release agent 14 attached to the surface after cleaning. The ratio of the amount of the release agent 14 attached to the surface before cleaning to the amount of the release agent 14 attached to the surface after cleaning (before removal/after removal) is shown in Table 2. This ratio is a value indicating cleaning efficiency. The values of cleaning efficiency of the ceramic compact pieces according to Examples 1 to 5 are within a preferred range (40% or more).

**[Table 2]**

| | Amount of Attachment to Surface before Cleaning | Ratio of Amount of Release Agent Attached to Surface (before removal/after removal) |
|---|---|---|
| Example 1 | A | 76 |
| Example 2 | B | 40 |
| Example 3 | A | 55 |
| Example 4 | B | 90 |
| Example 5 | B | 60 |
| Comparative Example 1 | D | 25 |
| Comparative Example 2 | D | 30 |

Then, in the step ST1, the ceramic compact pieces after cleaning were mixed with a fresh slurry raw material powder for ceramic substrates to produce a recycled slurry. The mass ratios (%) of the ceramic compact pieces after cleaning to the raw material powder of Examples 1 to 5 and Comparative Examples 1 and 2 are shown in Table 3.

The obtained slurry was formed into a sheet shape to obtain a sheet-shaped producing ceramic compact 11, and a release agent 14 was applied onto the sheet-shaped producing ceramic compact 11. Then, ceramic compact pieces obtained by applying the release agent 14 were subjected to degreasing sintering and final sintering to obtain ceramic substrates. As the release agent 14, boron nitride was used. In the release agent applying step ST3, the release agent 14 was applied onto the sheet-shaped producing ceramic compact 11 by spraying a mixture of a boron nitride powder and water.

The ceramic substrates obtained by sintering were subjected to a withstand voltage test and a bending strength test. Further, ceramic substrates for comparison (hereinafter referred to as reference ceramic substrates) were produced not from a recycled slurry but from a fresh slurry under the same conditions and subjected to the same tests.

In the withstand voltage test, a constant voltage was applied to the ceramic substrate based on a recycled slurry from the ceramic compact pieces according to each of Examples 1 to 5 and Comparative Examples 1 and 2 and the reference ceramic substrate based on a fresh slurry to compare the current value of leak current. The ceramic substrates according to Examples 1 to 5 and Comparative Examples 1 and 2 were evaluated according to the following criteria: "A" the current value was increased only by 0% or more and less than 0.5% as compared to that of the reference ceramic substrate, "B" the current value was increased only by 0.5% or more and less than 0.75% as compared to that of the reference ceramic substrate, "C" the current value was increased only by 0.75% or more and less than 1.0% as compared to that of the reference ceramic substrate, and "D" an earth fault occurred. The results of the withstand voltage test are shown in Table 3.

In the bending strength test, the three-point bending strength of the ceramic substrate based on a recycled slurry from the ceramic compact pieces according to each of Examples 1 to 5 and Comparative Examples 1 and 2 and the three-point bending strength of the reference ceramic substrate based on a fresh slurry were measured in accordance with JIS R1601. The ceramic substrates according to Examples 1 to 5 and Comparative Examples 1 and 2 were evaluated according to the following criteria: "A" the three-point bending strength was 99% or more of that of the reference ceramic substrate, "B" the three-point bending strength was 96% or more and less than 99% of that of the reference ceramic substrate, "C" the three-point bending strength was 94% or more and less than 96% of that of the reference ceramic substrate, and "D" the three-point bending strength was less than 94% of that of the reference ceramic substrate. The results of the bending strength test are shown in Table 3.

**[Table 3]**

| | Mass Ratio to Raw Material Powder [%] | Withstand Voltage Test | Bending Strength Test |
|---|---|---|---|
| Example 1 | 25 | A | A |
| Example 2 | 15 | B | B |
| Example 3 | 10 | A | A |
| Example 4 | 20 | C | B |
| Example 5 | 30 | C | C |
| Comparative Example 1 | 15 | D | D |
| Comparative Example 2 | 40 | D | C |

The amount of the component of the release agent 14 at the midpoint portion C1 of each of the ceramic substrates of Examples 1 to 5 is controlled in the cleaning step and the process of producing a slurry. The amounts of the component of the release agent 14 at the central portion P1 of the first surface S1, the central portion P2 of the second surface S2, and the midpoint portion C1 of each of the ceramic substrates of Examples 1 to 5 and Comparative Examples 1 and 2 were measured using an ICP emission spectrophotometer.

The ratio (mp1)/(mc1) of the amount of the component of the release agent 14 measured at the midpoint portion C1 (defined as mc1) to the amount of the component of the release agent 14 measured at the central portion P1 (or the central portion P2) (defined as mp1) of each of the ceramic substrates of Examples 1 to 5 and Comparative Examples 1 and 2 was calculated. The calculation results are as shown in Table 4. The ratio (mp1)/(mc1) of each of the ceramic substrates of Examples 1 to 5 was 5 or more. The amount mc1 of the component of the release agent 14 measured at the midpoint portion C1 in Examples 1 and 3 was less than 30 ppm by mass, that in Example 2 was 30 ppm by mass or more and less than 40 ppm by mass, and that in Examples 4 and 5 was 40 ppm by mass or more and 50 ppm by mass or less. On the other hand, in both of Comparative Examples 1 and 2, the amount mc1 of the component of the release agent 14 measured at the midpoint portion C1 was as large as more than 50 ppm by mass, and the amount of the component of the release agent 14 was larger in Comparative Example 1 than in Comparative Example 2.

**[Table 4]**

| | mC1 [ppm by mass] | mP1/mC1 |
|---|---|---|
| Example 1 | <30 | ≥5 |
| Example 2 | ≥30 and <40 | ≥5 |
| Example 3 | <30 | ≥5 |
| Example 4 | ≥40 and ≤50 | ≥5 |
| Example 5 | ≥40 and ≤50 | ≥5 |
| Comparative Example 1 | >50 | <5 |
| Comparative Example 2 | >50 | <5 |

Further, the ratio P1/P2 between the amount of the component of the release agent 14 at the central portion P1 of the first surface S1 and the amount of the component of the release agent 14 at the central portion P2 of the second surface S2 opposite to the first surface S1 in each of Examples 1 to 5 was 0.5 ≤ P1/P2 ≤ 2. In each of Examples 1 to 5, the amount of the component of the release agent 14 at the midpoint portion C1 was more than 0 ppm by mass and 50 ppm by mass or less.

This demonstrated that in the ceramic substrates excellent in dielectric strength and mechanical strength (e.g., bending strength) shown in Table 3, the amount of the component of the release agent 14 measured at the central portion P1 (or the central portion P2) was 5 times or more the amount of the component of the release agent 14 measured at the midpoint portion C1 that was a midpoint of a line segment connecting the central portion P1 of the first surface S1 and the central portion P2 of the second surface S2 of the ceramic substrate.

The at least one embodiment described above makes it possible to provide a ceramic substrate produced in high yield even when containing the component of the release agent 14, a ceramic circuit board, a semiconductor device, a method for producing a slurry, and a method for applying a release agent.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A ceramic substrate having a first surface as a front surface and a second surface as a back surface, wherein
when a midpoint of a line segment connecting a central portion P1 of the first surface and a central portion P2 of the second surface is defined as a midpoint portion C1, an amount of a component of a release agent measured at the central portion P1 of the first surface or the central portion P2 of the second surface is five times or more an amount of the component of the release agent measured at the midpoint portion C1.

2. The ceramic substrate according to claim 1, wherein a ratio P1/P2 between the amount of the component of the release agent measured at the central portion P1 of the first surface and the amount of the component of the release agent measured at the central portion P2 of the second surface satisfies 0.5 ≤ P1/P2 ≤ 2.

3. The ceramic substrate according to claim 1, wherein the amount of the component of the release agent measured at the midpoint portion C1 is more than 0 ppm by mass and 50 ppm by mass or less.

4. The ceramic substrate according to claim 2, wherein the amount of the component of the release agent measured at the midpoint portion C1 is more than 0 ppm by mass and 50 ppm by mass or less.

5. The ceramic substrate according to claim 1, wherein the component of the release agent is boron nitride.

6. The ceramic substrate according to claim 4, wherein the component of the release agent is boron nitride.

7. The ceramic substrate according to claim 1, which contains a nitride-based ceramic as a main component.

8. The ceramic substrate according to claim 4, which contains a nitride-based ceramic as a main component.

9. The ceramic substrate according to claim 6, which contains a nitride-based ceramic as a main component.

10. A ceramic circuit board using the ceramic substrate according to claim 1, the ceramic circuit board comprising at least one conductive portion bonded to at least one of the first surface and the second surface of the ceramic substrate.

11. A ceramic circuit board using the ceramic substrate according to claim 4, the ceramic circuit board comprising at least one conductive portion bonded to at least one of the first surface and the second surface of the ceramic substrate.

12. A ceramic circuit board using the ceramic substrate according to claim 9, the ceramic circuit board comprising at least one conductive portion bonded to at least one of the first surface and the second surface of the ceramic substrate.

13. The ceramic circuit board according to claim 10, wherein
the ceramic substrate and the conductive portion are bonded with a brazing material being interposed between them,
the brazing material contains at least an active metal, and
the brazing material contains at least one selected from among Ag, Al, Cu, Sn, In, and Mn as a metallic component other than the active metal.

14. The ceramic circuit board according to claim 12, wherein
the ceramic substrate and the conductive portion are bonded with a brazing material being interposed between them,
the brazing material contains at least an active metal, and
the brazing material contains at least one selected from among Ag, Al, Cu, Sn, In, and Mn as a metallic component other than the active metal.

15. The ceramic circuit board according to claim 14, wherein the active metal is at least one selected from among Ti, Zr, Nb, and Hf.

16. A semiconductor device comprising the ceramic circuit board according to claim 10 and a semiconductor element disposed on the ceramic circuit board.

17. A method for producing a slurry, comprising:
a cleaning step in which a ceramic sintered compact piece is cleaned to obtain a ceramic sintered compact piece from which part of a release agent has been separated; and
a mixing step in which, when an amount of a powder raw material of a fresh slurry is taken as 100% by mass, the ceramic sintered compact piece from which part of a release agent has been separated is added to and mixed with the fresh slurry in an amount of 25% by mass or less to obtain a recycled slurry.

18. A method for applying a release agent, comprising:
a cleaning step in which a ceramic sintered compact piece is cleaned to obtain a ceramic sintered compact piece from which part of a release agent has been separated;
an adjusting step in which a solution containing the release agent is prepared by adjusting a content of the separated release agent in the solution;
a dispersing step in which a concentration of the release agent contained in the solution adjusted in the adjusting step is uniformly dispersed; and
an applying step in which the solution subjected to the dispersing step is applied onto a sheet-shaped producing ceramic compact.

## Amended claims

### Amended claims under Art. 19.1 PCT

1. A ceramic substrate having a first surface as a front surface and a second surface as a back surface, wherein
when a midpoint of a line segment connecting a central portion P1 of the first surface and a central portion P2 of the second surface is defined as a midpoint portion C1, a component of a release agent is present at the midpoint portion C1, and an amount of a component of the release agent measured at the central portion P1 of the first surface or the central portion P2 of the second surface is five times or more an amount of the component of the release agent measured at the midpoint portion C1.

2. The ceramic substrate according to claim 1, wherein a ratio P1/P2 between the amount of the component of the release agent measured at the central portion P1 of the first surface and the amount of the component of the release agent measured at the central portion P2 of the second surface satisfies 0.5 ≤ P1/P2 < 2.

3. The ceramic substrate according to claim 1, wherein the amount of the component of the release agent measured at the midpoint portion C1 is more than 0 ppm by mass and 50 ppm by mass or less.

4. The ceramic substrate according to claim 2, wherein the amount of the component of the release agent measured at the midpoint portion C1 is more than 0 ppm by mass and 50 ppm by mass or less.

5. The ceramic substrate according to claim 1, wherein the component of the release agent is boron nitride.

6. The ceramic substrate according to claim 4, wherein the component of the release agent is boron nitride.

7. The ceramic substrate according to claim 1, which contains a nitride-based ceramic as a main component.

8. The ceramic substrate according to claim 4, which contains a nitride-based ceramic as a main component.

9. The ceramic substrate according to claim 6, which contains a nitride-based ceramic as a main component.

10. A ceramic circuit board using the ceramic substrate according to claim 1, the ceramic circuit board comprising at least one conductive portion bonded to at least one of the first surface and the second surface of the ceramic substrate.

11. A ceramic circuit board using the ceramic substrate according to claim 4, the ceramic circuit board comprising at least one conductive portion bonded to at least one of the first surface and the second surface of the ceramic substrate.

12. A ceramic circuit board using the ceramic substrate according to claim 9, the ceramic circuit board comprising at least one conductive portion bonded to at least one of the first surface and the second surface of the ceramic substrate.

13. The ceramic circuit board according to claim 10, wherein
the ceramic substrate and the conductive portion are bonded with a brazing material being interposed between them,
the brazing material contains at least an active metal, and
the brazing material contains at least one selected from among Ag, Al, Cu, Sn, In, and Mn as a metallic component other than the active metal.

14. The ceramic circuit board according to claim 12, wherein
the ceramic substrate and the conductive portion are bonded with a brazing material being interposed between them,
the brazing material contains at least an active metal, and
the brazing material contains at least one selected from among Ag, Al, Cu, Sn, In, and Mn as a metallic component other than the active metal.

15. The ceramic circuit board according to claim 14, wherein the active metal is at least one selected from among Ti, Zr, Nb, and Hf.

16. A semiconductor device comprising the ceramic circuit board according to claim 10 and a semiconductor element disposed on the ceramic circuit board.

17. A method for producing a slurry, comprising:
a cleaning step in which a ceramic sintered compact piece is cleaned to obtain a ceramic sintered compact piece from which part of a release agent has been separated; and
a mixing step in which, when an amount of a powder raw material of a fresh slurry is taken as 100% by mass, the ceramic sintered compact piece from which part of a release agent has been separated is added to and mixed with the fresh slurry in an amount of 25% by mass or less to obtain a recycled slurry.

18. A method for applying a release agent, comprising:
a cleaning step in which a ceramic sintered compact piece is cleaned to obtain a ceramic sintered compact piece from which part of a release agent has been separated;
an adjusting step in which a solution containing the release agent is prepared by adjusting a content of the separated release agent in the solution;
a dispersing step in which a concentration of the release agent contained in the solution adjusted in the adjusting step is uniformly dispersed; and
an applying step in which the solution subjected to the dispersing step is applied onto a sheet-shaped producing ceramic compact.
